**Europäisches Patentamt**

**European Patent Office**

**Office européen des brevets**

(11) Veröffentlichungsnummer: **0 113 895**
A1

(12) # EUROPÄISCHE PATENTANMELDUNG

(21) Anmeldenummer: 83112666.9

(22) Anmeldetag: 15.12.83

(51) Int. Cl.³: **H 01 L 21/60**, H 05 K 3/34, B 23 K 26/00, B 23 K 1/00, H 01 R 43/02

(30) Priorität: 21.12.82 DE 3247338

(43) Veröffentlichungstag der Anmeldung: 25.07.84 Patentblatt 84/30

(84) Benannte Vertragsstaaten: **CH DE FR GB LI NL**

(71) Anmelder: **SIEMENS AKTIENGESELLSCHAFT, Berlin und München Wittelsbacherplatz 2, D-8000 München 2 (DE)**

(72) Erfinder: **Raisig, Hermann, Schuckertstrasse 4, D-8000 München 70 (DE)**
Erfinder: **Unger, Gregor, Ing. Grad, Otto-Wagner-Strasse 10a, D-8034 Germering (DE)**
Erfinder: **Wirbser, Oscar, Dipl.-Ing., Kreuzlingerstrasse 73, D-8034 Germering (DE)**

(54) **Verfahren zum Laserlöten von flexiblen Verdrahtungen.**

(57) Zum Laserlöten beloteter Anschlüsse (7) von flexiblen, auf einer lichtdurchlässigen Trägerfolie (2) angeordneten Verdrahtungen, die an den Kontaktstellen mit einem Flußmittel versehen sind, werden die zu verbindenden Teile durch einen Niederhalter (8) aus lichtdurchlässigem Material zusammengehalten. Die Wärmezuführung für den Lötvorgang erfolgt berührungslos durch einen Laserstrahl (9). Beim Auftreffen des Laserstrahls (9) schmilzt das Lot der beiden Leiterbahnen (7) und erstarrt bei Wegnahme der Wärmezufuhr zu einer festen Lötverbindung.

SIEMENS AKTIENGESELLSCHAFT     Unser Zeichen
Berlin und München             VPA
                               82 P 2 0 8 8 E

Verfahren zum Laserlöten von flexiblen Verdrahtungen.

Beim Verbinden von zwei Teilen durch Löten war bisher entweder für eine direkte Wärmeübertragung die Metallisierung eines Teiles zugänglich oder es bestand die Möglichkeit, die Wärme für den Lötprozeß indirekt über belotete Leiterbahnen zu übertragen.

Das Punktschweißen (Löten) von Anschlüssen auf Hybridschaltungen wird erst in jüngster Zeit als mögliche Anwendung des Lasers in Betracht gezogen. Beim Schweißen werden die zu schweißenden Werkstoffe in die Schmelzphase gebracht, wodurch eine direkte Verbindung der beiden Werkstoffe erfolgt. Bedingung für eine dauernde Verbindung ist das Vorhandensein von genügend Material. Wenn dies nicht der Fall ist, muß das Lötverfahren angewendet werden. Dazu werden die Werkstoffe mit einer lötbaren Masse (Weich- oder Hartlot) überzogen. Der Laser wirkt dabei als Wärmequelle, die sehr präzise nur gerade auf die zu verbindenden Stellen einwirkt. Mit diesem Verfahren ist es nicht möglich, flexible Verdrahtungen auf Glassubstraten zu löten.

Der Erfindung liegt die Aufgabe zugrunde, ein Verfahren anzugeben, mit dem flexible Verdrahtungen gelötet werden können, die für eine Wärmezufuhr mit einem Lötbügel oder ähnlichem Werkzeug nicht zugänglich sind.

Diese Aufgabe wird dadurch gelöst, daß zum Löten flexibler, auf einer lichtdurchlässigen Trägerfolie angeordneten Verdrahtungen, die an den Kontaktstellen mit einem Fluß-

Wed 1 Plr/22.11.1982

- 2 - VPA

82 P 2088 E

mittel versehen sind, die zu verbindenden Teile durch einen Niederhalter aus lichtdurchlässigem Material so zusammengehalten werden, daß sie zueinander in der gewünschten Lage fixiert sind und die sich gegenüberliegenden Verdrahtungen mit ihren Lotoberflächen berühren und daß die berührungslose Wärmezuführung für den Lötvorgang durch einen Laserstrahl erfolgt. Durch die berührungslose Wärmezufuhr wird die Bruchgefahr bei Glassubstraten vermieden, da keine Kräfte auf das Substrat ausgeübt werden. Die Trägerfolie wird nicht geschädigt und die Teilung bleibt erhalten.

Nach einer Weiterbildung der Erfindung wird als Laser vorzugsweise ein Dauerstrich-Festkörperlaser Nd:YAG verwendet. Die Wellenlänge von 1,064 µm dieses Lasers eignet sich besonders für einen derartigen Lötvorgang.

Um die Wärme über eine größere Fläche einzubringen und die Trägerfolie nicht zu beschädigen, wird vorzugsweise ein defokussierter Laserstrahl verwendet. Mit dieser Lösung wird außerdem die Verbindung zwischen Leiter und Folie nicht beschädigt und außerdem auch die Metallisierung nicht durch Ablegieren beeinträchtigt. Außerdem wird dadurch auch eine Überhitzung vermieden.

Die Erfindung wird anhand der Figuren erläutert. Es zeigen:

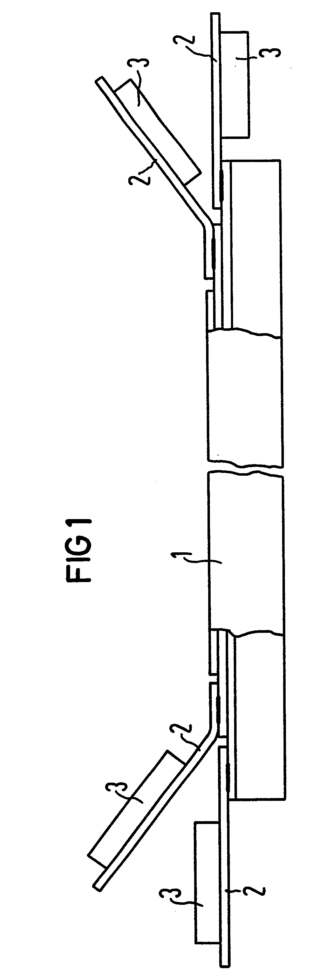

Figur 1 als Ausführungsbeispiel einen Glasträger in der Seitenansicht und

Figur 2 die Anwendung der Erfindung auf einen Ausschnitt eines derartigen Glasträgers.

Mit 1 ist ein Glasträger bezeichnet. Das Bezugszeichen 2 markiert die Anschlußverdrahtungen. Bausteine auf den Verdrahtungsfolien sind mit 3 bezeichnet.

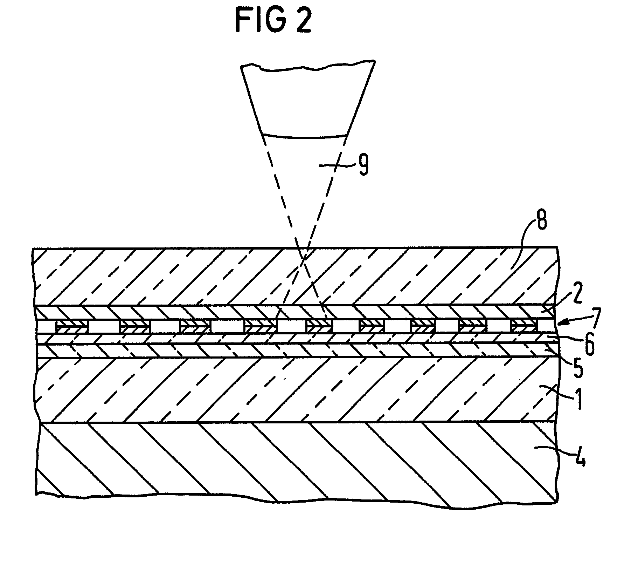

Nach der Darstellung in der Figur 2 liegt der Glasträger 1 auf einer Haltevorrichtung 4 auf. Glaslot 5 stellt die Verbindung zwischen dem Glasträger 1 und dem Glassubstrat 6 her. Das Bezugszeichen 7 markiert die Außenanschlüsse der zu verbindenden Leiterbahnen zwischen der Anschlußverdrahtung und dem Glassubstrat. Die zu verbindenden Teile werden durch einen Niederhalter 8 aus lichtdurchlässigem Material, zum Beispiel Glas, zusammengehalten. Mit 9 ist der angedeutete Laserstrahl bezeichnet.

Wie aus der Figur 2 hervorgeht, sind nach dem Ausführungsbeispiel die Leiterbahnen in der einen Richtung von der Polyimidfolie der flexiblen Ansteuerverdrahtung 2 und in der anderen Richtung von dem Glassubstrat 6 abgedeckt. Durch den Niederhalter 8 werden die zu verbindenden Außenanschlüsse zusammengehalten. Mit dem Dauerstrichlaser wird eine Wärmespur gezogen und ein Vorwärmen und Aufschmelzen des Lotes bewirkt. Darauf folgt ein spannungsfreies Erstarren des Lotes zu einer festen Lötverbindung. Mit diesem Verfahren läßt sich eine Vielzahl von nebeneinander liegenden Anschlüssen in einem Arbeitsgang mit einem Niederhalter durchführen.

Das Verfahren nach der Erfindung eignet sich insbesondere zum Löten von flexiblen Verdrahtungen auf Verdrahtungen von Leiterplatten aus Glas, Keramik, Kunststoffen.


3 Patentansprüche
2 Figuren

Patentansprüche

1. Verfahren zum Laserlöten beloteter Anschlüsse, d a -
d u r c h   g e k e n n z e i c h n e t , daß zum Löten
flexibel auf einer lichtdurchlässigen Trägerfolie angeordnete Verdrahtungen (2), die an den Kontaktstellen mit
einem Flußmittel versehen sind, die zu verbindenden Teile
(7) durch einen Niederhalter (8) aus lichtdurchlässigem
Material so zusammengehalten werden, daß sie zueinander
in der gewünschten Lage fixiert sind und die sich
gegenüberliegenden Verdrahtungen mit ihren Lotoberflächen
berühren und daß die berührungslose Wärmezuführung für
den Lötvorgang durch einen Laserstrahl (9) erfolgt.

2. Verfahren nach Anspruch 1, d a d u r c h   g e -
k e n n z e i c h n e t , daß als Laser vorzugsweise ein
Dauerstrich-Festkörperlaser Nd:YAG verwendet wird.

3. Verfahren nach Anspruch 1 und 2, d a d u r c h   g e -
k e n n z e i c h n e t , daß ein defokussierter Laserstrahl Verwendung findet.

# FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | IBM TECHNICAL DISCLOSURE BULLETIN, Band 22, Nr. 2, Juli 1979, New York, USA R.L. MELCHER "Laser-welded package for semiconductor and superconductor electronics", Seite 834 * Seite 834, der ganze Text, Figur * | 1,3 | H 01 L 21/60<br>H 05 K 3/34<br>B 23 K 26/00<br>B 23 K 1/00<br>H 01 R 43/02 |
| P,A | US-A-4 404 453 (GOTMAN) * Spalte 3, Zeile 39 - Spalte 4, Zeile 58, Figur 2 * | 1,3 | |
| A | EP-A-0 019 186 (SIEMENS) * Ansprüche 1,4,6 * | 1,2 | |
| A | US-A-3 657 508 (STUDNICK) * Spalte 3, Zeile 43 - Spalte 4, Zeile 6; Figur 1 * | 1 | RECHERCHIERTE SACHGEBIETE (Int. Cl. ³) |
| | | | B 23 K 1/00<br>B 23 K 26/00<br>H 01 L 21/60<br>H 05 K 3/00<br>H 05 K 3/34<br>H 01 R 43/02 |

Der vorliegende Recherchenbericht wurde für alle Patentansprüche erstellt.

| Recherchenort | Abschlußdatum der Recherche | Prüfer |
|---|---|---|
| BERLIN | 13-03-1984 | HAHN G |